# EUROPEAN PATENT SPECIFICATION

(11) **EP 4 348 223 B1**
(45) Date of publication and mention of the grant of the patent: **30.09.2026**
(21) Application number: 22716583.4
(22) Date of filing: 07.04.2022
(51) Int. Cl.: G01N 21/31, G01N 21/84, G01N 21/47

(54) **OPTICAL VEGETATION SENSOR UNIT**
OPTISCHE VEGETATIONSSENSOREINHEIT
UNITÉ DE CAPTEUR DE VÉGÉTATION OPTIQUE

(30) Priority: 28.05.2021 SE 2150678
(43) Date of publication of application: 10.04.2024
(73) Proprietor: HUSQVARNA AB, 561 82 Huskvarna (SE)
(72) Inventor: MERKLE, Martin, 89168 NIEDERSTOTZINGEN (DE); ANDRIOF, Frederik, 89171 ILLERKIRCHBERG (DE)
(86) International application number: PCT/SE2022/050350
(87) International publication number: WO 2022/250588

(56) References cited:
- EP-A1- 2 229 045
- US-B1- 6 542 772
- BARÓCSI A ET AL: "Two-wavelength, multipurpose, truly portable chlorophyll fluorometer and its application in field monitoring of phytoremediation; Two-wavelength chlorophyll fluorometer", MEASUREMENT SCIENCE AND TECHNOLOGY, IOP, BRISTOL, GB, vol. 11, no. 6, 1 June 2000 (2000-06-01), pages 717 - 729, XP020062956, ISSN: 0957-0233, DOI: 10.1088/0957-0233/11/6/315
- SCHREIBER U ET AL: "Portable, solid-state fluorometer for the measurement of chlorophyll fluorescence induction in plants", REVIEW OF SCIENTIFIC INSTRUMENTS, AMERICAN INSTITUTE OF PHYSICS, 2 HUNTINGTON QUADRANGLE, MELVILLE, NY 11747, vol. 46, no. 5, 1 May 1975 (1975-05-01), pages 538 - 542, XP002443201, ISSN: 0034-6748, DOI: 10.1063/1.1134252
- GROSSMANN KATJA ET AL: "PhotoSpec: A new instrument to measure spatially distributed red and far-red Solar-Induced Chlorophyll Fluorescence", REMOTE SENSING OF ENVIRONMENT, ELSEVIER, XX, vol. 216, 13 July 2018 (2018-07-13), pages 311 - 327, XP085453245, ISSN: 0034-4257, DOI: 10.1016/J.RSE.2018.07.002

## Description

### Technical field

The present disclosure relates to an optical vegetation sensor unit comprising at least two light sources with mutually different light spectra, illuminating a surface to be tested, at least one photo sensor measuring reflected light from said surface, and an amplifier processing the signal from the photo sensor.

The disclosure further relates to a robotic lawn care device comprising such an optical vegetation sensor as well as a method for providing a vegetation metric.

### Background

Such sensor units can be used in robotic lawn mowers or other lawn care devices as well as in agriculture equipment of different kinds. One example of such a sensor is shown in EP-2229045-A1, which uses a two light sources, one emitting visible light and one emitting infrared light. The corresponding light sensor reading is used to determine a normalized difference vegetation index, NDVI, which roughly indicates how green a grass surface is, for instance.

Such data could be used, for instance, to determine a suitable lawn care function, to navigate a robotic lawn mower, or to avoid an obstacle, etc.

One problem associated with sensor units of this kind is how to improve the reliability of data provided by the sensor.

### Summary

One object of the present disclosure is therefore to provide an optical vegetation sensor unit with improved reliability. This object is achieved by an optical vegetation sensor as defined in claim 1. More specifically, in an optical vegetation sensor of the initially mentioned kind, there is provided a compensation input to the amplifier. The vegetation sensor unit is configured to measure the output from the amplifier when the light sources are wholly or partly turned off and to apply a compensation signal to the compensation input that drives the amplifier output to a predetermined set point. Measurements are then carried out to measure the reflected light with the compensation signal applied to the amplifier. This makes it possible to more or less completely eliminate the bias given to the sensor by ambient light, which in many cases could otherwise almost saturate the latter stages of the measurement. This provides an improved reliability of the readings from the vegetation sensor.

A digital to analog converter, DAC, may be connected to the compensation input, and the DAC may be driven by a controller to drive the amplifier output to the predetermined set point voltage.

The amplifier circuit may be based on an operational amplifier. If so, the predetermined set point voltage may be approximately half of the driving voltage of the operational amplifier.

The light detector and the compensation input may both be connected to an operational amplifier inverse input.

The amplifier circuit may be a transimpedance amplifier.

The compensation signal may be updated with a frequency in the range 100 - 5kHz. The light sources may be periodically activated with a frequency exceeding 5kHz and a high pass filter at or after the amplifier may filter to cancel variations with lower frequencies. This serves to deal with unusually quick variations in ambient light.

The present disclosure also considers a robotic lawn care device comprising an optical vegetation sensor as defined above.

Th present disclosure further considers a method for providing a vegetation metric using an optical vegetation sensor unit comprising at least two light sources with mutually different spectra, illuminating a surface to be tested, at least one photo sensor measuring reflected light from said surface, and an amplifier processing the signal from the photo sensor. The method includes measuring the output from the amplifier when the light sources are wholly or partly turned off, applying a compensation signal that wholly or partly cancels the signal from the photo sensor; and measuring the reflected light with the compensation signal applied to the amplifier.

According to the claimed invention, this method is varied in the corresponding manner as the above-defined sensor unit.

### Brief description of the drawings

Fig 1 shows a robotic garden tool in the form of a lawn mower.
Fig 2 illustrates a working area processed by a robotic garden tool.
Fig 3A and 3B schematically shows the location and the configuration of a vegetation sensor in a robotic garden tool.
Fig 4A and 4B illustrates absorption properties at different wavelengths.
Fig 5 illustrates an input amplifier stage for a vegetation sensor.
Fig 6 schematically illustrates a method for adjusting an amplifier.

### Detailed description

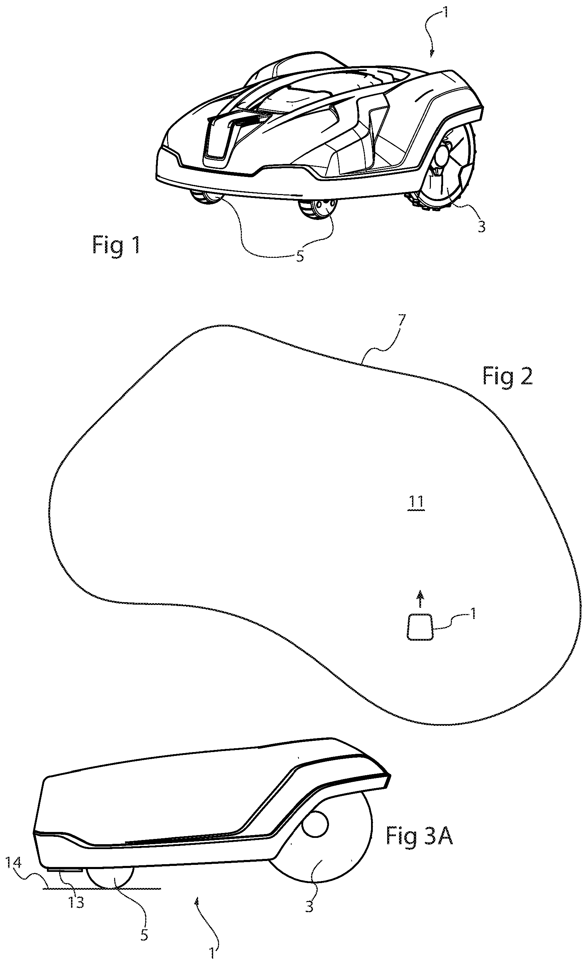

The present disclosure relates to robotic garden tools and similar agricultural equipment that can utilize a vegetation sensor for detecting vegetation or estimating the condition of vegetation. Fig 1 shows a robotic garden tool in the form of a robotic lawn mower 1. Such a robotic lawn mower can travel autonomously over a designated working area while processing, typically cutting, the lawn therein by means of a cutting implement (not shown). The robotic lawn mower 1 in the illustrated example comprises two rear driven wheels 3 and two undriven front wheels 5, although other configurations are certainly possible, such as all-wheel driven or articulated configurations.

Fig 2 illustrates a robotic garden tool such as a lawn mower 1 processing a working area 11. The working area may typically be enclosed by a buried cable 7 that is sensed by the lawn mower 1, as is well known per se, to enable the lawn mower to stay within the working area 11, although other navigation means such as based on satellite navigation is also possible. While processing a lawn or other vegetation, the robotic garden tool 1 can measure qualities of the vegetation and soil underneath to determine vegetation conditions such as the moisture of the soil and/or the amount of moisture on top of the lawn surface, as well as the "greenness" of the vegetation.

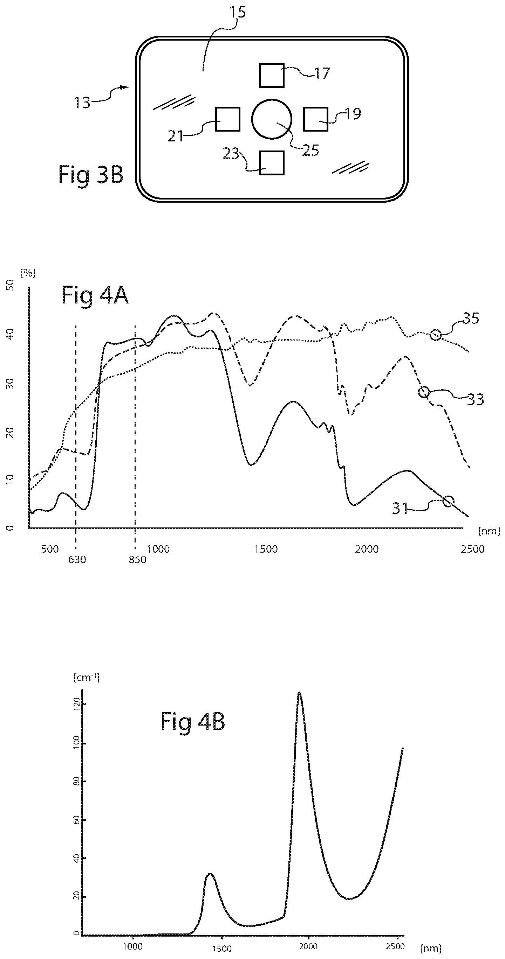

Fig 3A and 3B schematically shows the location and the configuration of a vegetation sensor in a robotic garden tool illustrated with the example of a lawn mower 1. A vegetation sensor 13 may be located anywhere on a lawn mower 1 where it can face the vegetation surface, but typically on the bottom side of the lawn mower where the distance to the surface in question is a few centimeters at the most. In the illustrated example, the vegetation sensor 13 is located in front of the front wheels 5 which implies some advantages. For instance, it may be determined by means of the vegetation sensor 13 that the lawn mower is about to enter an area with temporarily sensitive vegetation that should be processed another day to avoid being damaged by the lawn mower wheels 5, 3. If so, the lawn mower 1 may reverse and change its heading to instead process other areas in the working area (11, cf. fig 2). Needless to say, other examples of locating the vegetation sensor 13 on the lawn mower exist and may provide other advantages.

Fig 3B schematically shows a vegetation sensor 13 as the one of fig 3A, in a front view as seen from the vegetation surface/lawn. The vegetation sensor 13 comprises a number of optical components, as will be described, which are protected by an outer translucent layer 15. This layer may comprise borosilicate glass that has been found to provide suitable optical properties over a wide range of light wavelengths, even if other options are possible such as different plastic materials. The vegetation sensor 13 further comprises at least two, in the illustrated case four, light sources 17, 19, 21, 23, typically light emitting diodes, LEDs. At least two of those emit light with mutually different spectra. The vegetation sensor 13 further comprises a light sensor 25, typically a photo diode, that outputs a current corresponding to the amount of received light.

The LEDs and the photo diodes may be placed in several different configurations, the one illustrated in fig 3B, where the photo diode is located in the center and the LEDs are disposed one in each 90-degree segment, being only one example. For instance, the LEDs may be arranged in a line, one side of which faces one or more photo diodes. It is possible to arrange one photo diode in a pair with each LED, where the LED/sensor in each are sequentially activated.

One or more of the light sources 17, 19, 21, 23 are sequentially activated to illuminate the tested surface, and the light sensor 25 produces a signal which corresponds to the amount of light reflected by the surface in the wavelength range in question. This makes it possible to carry out certain vegetation measurements. Vegetation measurements in this context encompasses several different types of measurements. For instance, it is possible to measure the "greenness" of a lawn or other types of vegetation, which can determine for instance whether the grass should be cut and at what height, or can initiate watering of the lawn at that location by means of the robot itself or other devices. It also makes it possible to detect for instance if grass is present under the sensor or whether the lawn mower has reached a patch of bare soil or a paved area or the like. It is also possible to measure the level of moisture of the surface under the lawn mower whether it is grass or bare soil. All these measurements are considered vegetation measurements.

Fig 4A illustrates how a normalized difference vegetation index, NDVI, can be determined. This requires a measure of the reflectance at two different wavelength ranges. In this disclosure a red- and a near-infrared measurement may be carried out. The red measurement is carried out with a wavelength range including 630 nm. The width of this range need not be large. The near-infrared light is produced at a wavelength range including 850 nm. Those wavelengths are indicated in fig 4A. Fig 4A also indicates the typical reflectance for different vegetation conditions and soil over a spectrum. The solid line 31 illustrates typical reflectance, as a percentage, for green, well-watered grass throughout the spectrum, while the dashed line 33 illustrates corresponding reflectance for dry grass, and the dotted line 35 the corresponding reflectance for bare soil. By measuring the responses for the individual wavelength ranges produced by two different light sources one reading for Red (e.g. 630 nm) and one for near infrared, NIR, (e.g.850 nm) can be obtained. A normalized difference vegetation index, NDVI, can then be determined as: $NDVI = \frac{NIR - Red}{NIR + Red}$

NDVI will then be a number between -1 and 1 and indicate the following conditions:

| | |
|---|---|
| NDVI<0 | Water (liquid) |
| -0.1<NDVI<0.1 | Sand/soil |
| 0.1<NDVI<0.4 | Typical lawn |
| NDVI close to 1 | Lush green vegetation |

By using sensed NDVI data, the robotic lawn care device may as mentioned carry out decisions on if and how to process a lawn or to navigate thereon. It is however also possible to upload the data to a mapping device in the lawn care device itself or to another device that is capable of communicating with the lawn care device. This may for instance be a central lawn care service that is capable of controlling several devices in a lawn care system, for instance controlling a stationary watering system that waters the lawn based on data from the lawn care device and other inputs such as whether services, and the like. This allows the lawn care system for instance to water a local patch of lawn that is turning brown, while refraining from watering lusher areas. At the same time this may be determined for instance depending on expected rainfall, etc. By employing an intelligent and detailed processing in this way, a lawn or other vegetation area may be maintained with considerably less water.

In addition to (or as an alternative to) the NDVI measurement, a moisture measurement may be useful, typically to assess the need for watering a lawn or other vegetation.

There exist synergies between those measurements. Typically, the NVDI enhances the precision of the moisture measurement, as the absorption by the vegetation in a spectrum where water absorbs a large portion of incoming light also can be taken into account.

The other way around, the moisture measurement can be used to modify the NDVI measurement to a more precise value as the moist affects the NDVI measurement to some extent even without directly affecting the vegetation as such. It is therefore possible to optionally improve also the NDVI value with a moisture compensation factor that can be determined from the moisture reading based on circumstances in the application.

The moisture can be determined by using at least one additional light source, typically a LED producing light in a range including 1450 nm. Fig 4B illustrates the absorption (i.e. approximately the inverse parameter compared to the one illustrated in fig 4A) of light in water over a wide range of wavelengths. As can be seen, one absorption peak is indicated approximately at about 1450 nm. The present disclosure therefore considers in one embodiment to use that wavelength for detection of water/moisture as such. As shown, another, even more salient, peak is shown at about 1950 nm and could be used as well. However, both light diodes producing that wavelength and photo sensors capable of detecting such wavelengths are comparatively expensive if a reasonable precision is expected.

Similarly, to the determining of the NDVI as described earlier, a normalized ratio can be determined by comparing the absorption (or reflection) at 1450 nm and another wavelength, in a preferred example 1300 nm, although one of the wavelengths used for the NDVI determination could be used instead, typically 850 nm. Thereby, a corresponding moisture metric is obtained.

To carry out both these measurements, the light sources or LEDs 17, 19, 21, and 23 may be sequentially lit producing light at 630 nm, 850 nm, 1300 nm, and 1450 nm, respectively. This can be done in any order and the corresponding reflection is measured. As mentioned, 630 and 850 or 1050 nm are preferred for NDVI determination, although other wavelengths are possible. In a moisture measurement 1450 or 1950 nm and one shorter wavelength are used. The present disclosure is not restricted to carrying out more than one measurement including two different wavelengths, although the measurements do provide synergies, and therefore using three or four different wavelengths do confer additional advantages.

Useful examples of LEDs for light sources include:

| Wavelength [nm] | Type | Approximate bandwidth [nm] | Example |
|---|---|---|---|
| 630 | AlInGaP | 18 | VLDS1235G-08 |
| 850 | AlGaAs | 30 | 15412085A2070 |
| 1050 | GaAs | 80 | EOLS-1050-199 |
| 1300 | InGaAsP | 90 | EOLS-1300-843 |
| 1450 | InGaAsP | 90 | EOLS-1450-843 |

Available from Vishay Intertechnology, Inc, Würth Elektronik elSos GmbH & Co. KG and EPIGAP Optronic GmbH, respectively.

A light sensor such as a photo diode 25 as shown in fig 3B provides a very small current as an output, and therefore it is proposed to include an amplifier that amplifies the photo sensor signal before being used for processing. A transimpedance amplifier is proposed, which can be accomplished with a single operational amplifier and converts an input current proportionally to an output voltage.

One problem in this context is that the measurement is heavily influenced by ambient light which is much stronger than the light from the light sources 17-23 used for measurements. Further, that light is provided with a very broad and unpredictable wavelength range. Typically, sunlight provides more than1300 W/m2 while a typical LED produces about 1 W/m2 at a 10cm distance. This means that the data from the measurement more or less drowns in ambient light and only about 1 bit in an 8 bit signal would be directly related to the actual measurement. As the wavelengths of the ambient light can vary over the day, with weather, and with reflections of different types, it is very difficult to compensate for this with digital post-processing.

One conceivable solution would instead be to filter out the sunlight as it may be considered to vary only slowly. The light sources can be made to flash with a kHz frequency and filtering out signals with lower frequencies can to some extent reduce the sunlight influence. This, although a possible solution, does require additional feedback that can induce stability issues.

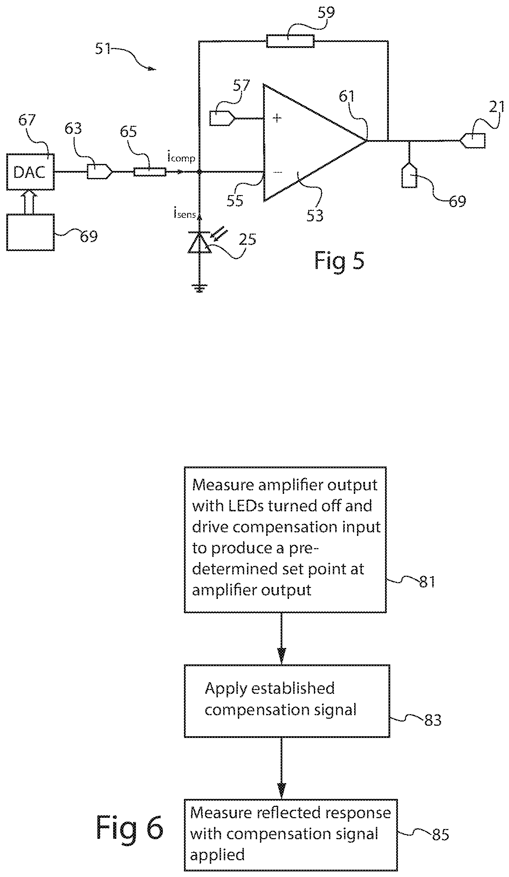

The present disclosure instead proposes a solution that cancels the sunlight as early as possible in the sensor circuit. This is illustrated schematically in fig 5, which shows a transimpedance input amplifier stage 51 for a vegetation sensor according to the present disclosure. The amplifier stage 51 comprises an operational amplifier 53, where a photo sensor 25 is connected to the amplifier inverting input 55. The inverting input 55 is low-ohmic and well suited to handle a weak current from the photo diode. The non-inverting input 57 may be kept at a constant voltage. A feedback resistor 59 with the resistance R is connected between the amplifier output 61 and the inverting input 55. For filtering purposes, a capacitor (not shown) may be connected in parallel with the feedback resistor 59. In this connection, the operational amplifier provides an output voltage Uₒᵤₜ that is directly proportional to the input current **I**ᵢₙ as **Uₒᵤₜ**=**Iᵢₙ*R**.

In the present disclosure, the amplifier circuit is configured to more or less substantially cancel the influence from ambient light. This is accomplished by providing a compensation input 63, 65 provided to the amplifier circuit 51. This input may be controlled by a digital to analog converter, DAC, 67 which in turn may be controlled by a controller 69 or other processing unit. As an alternative to a DAC 67, a set of resistors that are selectively connectable by means of switches could be considered, as long as a desired voltage can be provided to the compensation input 63, 65. It is possible to provide a voltage to the compensation input pin 63 that by means of the compensation input resistor produces a current i_{comp}, that compensates for the part of the light sensor current iₛₑₙₛ that results from ambient light.

In use, the light sources 19-23 are temporarily turned off such that the light sensor 25 output corresponds to the one from ambient light. In this state, the output 61 from the amplifier is measured by the controller 69. The controller 69 then regulates the DAC 67 to provide a compensation signal that drives the amplifier output 61 to a predetermined set point. This set point may typically be at half the driving voltage of the operational amplifier 53, so if the driving voltage is 5V, the output is driven to 2.5V. Of course, other set points are conceivable.

Once the desired set point is reached, the measurements are carried out by sequentially activating the light sources 19-23 and measuring the corresponding response while keeping the compensation input voltage constant. The ambient light in this case is compensated for, and as this is done at the sensor input, all post-processing of the measurement, e.g. A/D conversion and digital processing is improved.

The compensation control scheme described above is typically repeated regularly to take into account any variations in ambient light, e.g. a cloud covering the sun or the lawn mower changing its heading such that more or less ambient light affects the measurements. Such variations however are typically slow, so the compensation control scheme need not be carried out at a greater frequency than for instance 50 Hz or even much slower. However, 100 Hz - 5kHz is considered a suitable range for the updating frequency. As a comparison, the light sources may be flashed at several kHz. As an optional addition, it is possible still to take advantage of the relatively high frequency of the activation of the light sources 19-21 by applying a high pass filter after the amplifier circuit 51. This may be used to deal with even quicker variations in ambient light which can be filtered out.

Fig 6 in a flow chart schematically illustrates a method according to the present disclosure. In a first step, the LEDs are turned off and the controller drives the DAC to produce a desired output at the amplifier circuit 81, which can be accomplished for instance with a software routine. The resulting compensation signal is applied 83 kept at the compensation input during measurement 85 of reflected light when the LEDs are sequentially activated.

The invention is not restricted to the described embodiments and may be varied and altered in different ways within the scope of the appended claims.

## Claims

1. An optical vegetation sensor unit (13) comprising at least two light sources (17, 19, 21, 23) with mutually different light spectra, illuminating a target surface (14) to be evaluated, at least one photo sensor (25) measuring reflected light from said target surface, and an amplifier circuit processing (51) the signal from the photo sensor, **characterized by** a compensation input (63, 65) provided to said amplifier circuit, wherein the vegetation sensor unit is configured to
- measure the output (69) from the amplifier circuit when the light sources are wholly or partly turned off
- apply a compensation signal that drives the amplifier circuit output to a predetermined set point voltage; and
- measure the reflected light with the compensation signal applied to the amplifier circuit.

2. Optical vegetation sensor according to claim 1, wherein a digital to analog converter, DAC, (67) is connected to the compensation input, and the DAC is driven by a controller (69) to drive the amplifier output to the predetermined set point voltage.

3. Optical vegetation sensor according to claim 1 or 2, wherein the amplifier circuit is based on an operational amplifier (53).

4. Optical vegetation sensor according to claim 3, wherein the predetermined set point voltage is approximately half of the driving voltage of the operational amplifier (53).

5. Optical vegetation sensor according to claim 3 or 4, wherein the light detector and the compensation input are both connected to an operational amplifier inverse input (55).

6. Optical vegetation sensor according to any of the preceding claims
wherein the amplifier circuit (51) is a transimpedance amplifier.

7. Optical vegetation sensor according to any of the preceding claims
wherein the compensation signal is updated with a frequency in the range 100Hz - 5kHz.

8. Optical vegetation sensor according to any of the preceding claims
wherein the light sources are periodically activated with a frequency exceeding 5kHz and a high pass filter at or after the amplifier filters to cancel variations with lower frequency.

9. A robotic lawn care device (1) comprising an optical vegetation sensor according to any of claim 1-8.

10. A method for providing a vegetation metric using an optical vegetation sensor unit comprising at least two light sources with mutually different spectra, illuminating a surface to be tested, at least one photo sensor measuring reflected light from said surface, and an amplifier processing the signal from the photo sensor, **characterized by**
- measuring (81) the output from the amplifier when the light sources are wholly or partly turned off
- applying (83) a compensation signal that drives the amplifier circuit output to a predetermined set point voltage; and
- measuring (85) the reflected light with the compensation signal applied to the amplifier.

## Patentansprüche

1. Einheit (13) eines optischen Vegetationssensors, umfassend mindestens zwei Lichtquellen (17, 19, 21, 23) mit voneinander verschiedenen Lichtspektren, die eine auszuwertende Zieloberfläche (14) beleuchten, mindestens einen Photosensor (25), der von der Zieloberfläche reflektiertes Licht misst, und eine Verstärkerschaltung (51), die das Signal von dem Photosensor verarbeitet, **gekennzeichnet durch** einen Kompensationseingang (63, 65), der an die Verstärkerschaltung bereitgestellt ist, wobei die Vegetationssensoreinheit konfiguriert ist zum
- Messen des Ausgangs (69) von der Verstärkerschaltung, wenn die Lichtquellen vollständig oder teilweise ausgeschaltet sind
- Anlegen eines Kompensationssignals, das den Verstärkerschaltungsausgang auf eine vorbestimmte Sollwertspannung treibt; und
- Messen des reflektierten Lichts mit dem an die Verstärkerschaltung angelegten Kompensationssignal.

2. Optischer Vegetationssensor nach Anspruch 1, wobei ein Digital-AnalogWandler, DAC, (67) mit dem Kompensationseingang verbunden ist und der DAC durch eine Steuerung (69) getrieben wird, um den Verstärkerausgang auf die vorbestimmte Sollwertspannung zu treiben.

3. Optischer Vegetationssensor nach Anspruch 1 oder 2, wobei die Verstärkerschaltung auf einem Operationsverstärker (53) basiert.

4. Optischer Vegetationssensor nach Anspruch 3, wobei die vorbestimmte Sollwertspannung etwa die Hälfte der Treibspannung des Operationsverstärkers (53) beträgt.

5. Optischer Vegetationssensor nach Anspruch 3 oder 4, wobei der Lichtdetektor und der Kompensationseingang beide mit einem invertierenden Eingang (55) des Operationsverstärkers verbunden sind.

6. Optischer Vegetationssensor nach einem der vorstehenden Ansprüche, wobei die Verstärkerschaltung (51) ein Transimpedanzverstärker ist.

7. Optischer Vegetationssensor nach einem der vorstehenden Ansprüche, wobei das Kompensationssignal mit einer Frequenz in dem Bereich von 100 Hz-5 kHz aktualisiert wird.

8. Optischer Vegetationssensor nach einem der vorstehenden Ansprüche, wobei die Lichtquellen mit einer Frequenz, die 5 kHz übersteigt, periodisch aktiviert werden und ein Hochpassfilter an oder nach dem Verstärker filtert, um Schwankungen mit niedrigerer Frequenz aufzuheben.

9. Roboter-Rasenpflegevorrichtung (1), umfassend einen optischen Vegetationssensor nach einem der Ansprüche 1 bis 8.

10. Verfahren zum Bereitstellen einer Vegetationsmetrik unter Verwendung einer Einheit des optischen Vegetationssensors, umfassend mindestens zwei Lichtquellen mit voneinander verschiedenen Spektren, die eine zu prüfende Oberfläche beleuchten, mindestens einen Photosensor, der von der Oberfläche reflektiertes Licht misst, und einen Verstärker, der das Signal von dem Photosensor verarbeitet, **gekennzeichnet durch**
- Messen (81) des Ausgangs von dem Verstärker, wenn die Lichtquellen vollständig oder teilweise ausgeschaltet sind
- Anlegen (83) eines Kompensationssignals, das den Verstärkerschaltungsausgang auf eine vorbestimmte Sollwertspannung treibt; und
- Messen (85) des reflektierten Lichts mit dem an den Verstärker angelegten Kompensationssignal.

## Revendications

1. Unité de capteur de végétation optique (13) comprenant au moins deux sources de lumière (17, 19, 21, 23) avec des spectres de lumière mutuellement différents, éclairant une surface cible (14) à évaluer, au moins un capteur photo (25) mesurant de la lumière réfléchie à partir de ladite surface cible, et un circuit amplificateur (51) traitant le signal à partir du capteur photo,
**caractérisée par** une entrée de compensation (63, 65) fournie audit circuit amplificateur, dans laquelle l'unité de capteur de végétation est configurée pour
- mesurer la sortie (69) du circuit amplificateur lorsque les sources de lumière sont totalement ou partiellement éteintes
- appliquer un signal de compensation qui amène la sortie de circuit amplificateur à une tension de point de consigne prédéterminée ; et
- mesurer la lumière réfléchie avec le signal de compensation appliqué au circuit amplificateur.

2. Capteur de végétation optique selon la revendication 1, dans lequel un convertisseur numérique-analogique, DAC, (67) est connecté à l'entrée de compensation, et le DAC est commandé par un dispositif de commande (69) pour amener la sortie d'amplificateur à la tension de point de consigne prédéterminée.

3. Capteur de végétation optique selon la revendication 1 ou 2, dans lequel le circuit amplificateur est sur la base d'un amplificateur opérationnel (53).

4. Capteur de végétation optique selon la revendication 3, dans lequel la tension de point de consigne prédéterminée est approximativement la moitié de la tension de commande de l'amplificateur opérationnel (53).

5. Capteur de végétation optique selon la revendication 3 ou 4, dans lequel le détecteur de lumière et l'entrée de compensation sont tous deux connectés à une entrée inverse d'amplificateur opérationnel (55).

6. Capteur de végétation optique selon l'une quelconque des revendications précédentes, dans lequel le circuit amplificateur (51) est un amplificateur à transimpédance.

7. Capteur de végétation optique selon l'une quelconque des revendications précédentes, dans lequel le signal de compensation est mis à jour avec une fréquence comprise dans la plage allant de 100 Hz à 5 kHz.

8. Capteur de végétation optique selon l'une quelconque des revendications précédentes, dans lequel les sources de lumière sont périodiquement activées avec une fréquence supérieure à 5 kHz et un filtre passe-haut au niveau ou en aval des filtres d'amplificateur pour éliminer des variations avec une fréquence plus basse.

9. Dispositif robotique d'entretien de pelouses (1) comprenant un capteur de végétation optique selon l'une quelconque des revendications 1 à 8.

10. Procédé destiné à fournir un indicateur de végétation à l'aide d'une unité de capteur de végétation optique comprenant au moins deux sources de lumière avec des spectres mutuellement différents, éclairant une surface à tester, au moins un capteur photo mesurant de la lumière réfléchie à partir de ladite surface, et un amplificateur traitant le signal à partir du capteur photo, **caractérisé par**
- la mesure (81) de la sortie de l'amplificateur lorsque les sources de lumière sont totalement ou partiellement éteintes
- l'application (83) d'un signal de compensation qui amène la sortie de circuit amplificateur à une tension de point de consigne prédéterminée ; et
- la mesure (85) de la lumière réfléchie avec le signal de compensation appliqué à l'amplificateur.
